# EUROPEAN PATENT SPECIFICATION

(11) **EP 1 360 722 B1**
(45) Date of publication and mention of the grant of the patent: **28.12.2016**
(21) Application number: 02740056.3
(22) Date of filing: 21.01.2002
(51) Int. Cl.: H01L 23/498, H01L 21/68, H01L 23/31, H01L 21/56, H01L 21/683

(54) **METHOD OF MANUFACTURING A SEMICONDUCTOR DEVICE**
VERFAHREN ZUR HERSTELLUNG EINER HALBLEITERVORRICHTUNG
PROCEDÉ POUR LA FABRICATION D'UN DIPOSITIF SEMI-CONDUCTEUR

(30) Priority: 09.02.2001 EP 01200496
(43) Date of publication of application: 12.11.2003
(73) Proprietor: Taiwan Semiconductor Manufacturing Co., Ltd., Hsin-Chu, 300-77 (TW)
(72) Inventor: VAN VEEN, Nicolaas, J., A., NL-5656 AA Eindhoven (NL); DE SAMBRE, Marc, A., NL-5656 AA Eindhoven (NL); WEISS, Thomas, NL-5656 AA Eindhoven (NL)
(74) Representative: Nederlandsch Octrooibureau
(86) International application number: PCT/IB2002/000178
(87) International publication number: WO 2002/063683

(56) References cited:
- EP-A- 0 260 490
- JP-A- 2000 021 906
- US-A- 4 246 595
- US-A- 4 709 254
- US-A- 4 908 937
- US-A- 5 291 019
- US-A- 5 615 476
- US-A- 5 620 928
- US-A- 5 840 417
- US-A- 5 915 170
- US-A- 5 990 546
- US-A- 6 037 192
- US-A- 6 166 433

## Description

The invention relates to a method of manufacturing a semiconductor device according to the preamble of claim 1.

Such a device comprises, for example, a diode or transistor as the active element, and can suitably be used for many applications. Surface mounting is attractive, in particular, because the amount of surface area that is taken up when use is made of this technique is small.

Such a method is disclosed in United States patent specification US 5,776,798, published on 7 July 1998. In said document a description is given of a method wherein a semiconductor body is electroconductively secured, by means of the connection regions of an active element, onto a conductor pattern that is situated on a side of, for example, a printed circuit board. The other side of said printed circuit board is also provided with a conductor pattern which is connected to the other conductor pattern by means of electroconductive vias in the printed circuit board. After securing the semiconductor body onto the printed circuit board, said semiconductor body is provided with a synthetic resin envelope, and an individual device is obtained, for example, by sawing through the envelope and the printed circuit board.

A drawback of such a method resides in that a device obtained by means of said method still takes up comparatively much space. In addition, the method is comparatively laborious and hence expensive.

US-A-4 246 595 relates to bonding of principal faces of semiconductor devices by means of a bond layer on one face (lower face) of a heat-resistive flexible synthetic resin film, for example, polyimide film, the other face (upper face) of the heat-resistive flexible synthetic resin film has bonded wiring conductor films of a specified wiring pattern, and specified parts of electrode metal layers or specified regions on the principal face of the semiconductor devices and specified parts of the wiring conductor films on the resin film are connected by conductor films formed extending between them through through-holes with sloped wall formed on the resin film. Also, a thin reinforcing frame of a metal film, formed on said one (lower) face of the resin film with a specified pattern, may be connected to the wiring conductor films through other through-holes with sloped wall.

US-A-6 166 433 relates to a semiconductor device including a semiconductor chip, an FPC tape for mounting the semiconductor chip thereto, a mold resin for protecting the semiconductor chip, and metal balls provided on the FPC tape for connecting the semiconductor chip to a circuit board. The mold resin has the glass transition temperature not lower than 200 DEG C., the coefficient of linear expansion in the range from 13 to 18 ppm/ DEG C., and Young's modulus in the range from 1500 to 3000 kg/mm2, whereby warpage of the semiconductor device is mitigated. The semiconductor device can also include a buffer layer. The semiconductor device can be manufactured by collectively molding a plurality of semiconductor chips mounted to the FPC tape and by cutting the molded article into individual semiconductor packages.

US-A-5 840 417 relates to electrically conductive sheet material preforms that are useful in bonding of electronic components as well as in the formation of electronic circuits. The preforms, which comprise a multiplicity of electrically conductive adhesive members, each being separated from each other by means of a non-electrically conductive adhesive, are particularly useful in the assembly of multi-chip modules and multilayer electronic devices.

US-A-5 620 928 relates to a method of manufacturing an integrated circuit package assembly including (i) an integrated circuit die having a bottom surface and a plurality of input/output terminals, (ii) electrically conductive traces and/or contacts accessible from outside the assembly, and (iii) an encapsulating material encapsulating the integrated circuit die and portions of the electrically conductive traces and/or contacts will be disclosed. The method includes the following steps. First, a temporary support substrate or carrier having a top surface is provided for supporting the integrated circuit package as the package is being assembled. Then, the integrated circuit die is detachably supported on the top surface of the temporary support substrate. Each of the input/output terminals on the integrated circuit die are electrically connected to the electrically conductive traces and/or contacts. Next, the integrated circuit die and at least a portion of the electrically conductive traces and/or contacts are encapsulated with the encapsulating material such that the bottom surface of the integrated circuit die supported by the temporary support substrate is not covered by the encapsulating material. Finally, the encapsulated integrated circuit die is detached from the temporary support substrate.

US-A-4 709 254 relates to a carrier element for an IC-module for incorporation into an identification card. The element includes a flexible carrier film supporting conductive leads and contact pads. A semi-conductor chip is electrically connected to the leads and pads. Cast resin surrounds the chip and carrier film, including the carrier pads, to form a solid carrier element capable of resisting mechanical stresses.

US-A-4 908 937 relates to a method for installing an electronic component and its electrical connections on a support provided with a cavity to house said component. A metallic layer is cut out into zones on which there is deposited a layer of polyimide which mechanically holds the said zones during the operations for the electrical connection of the electronic component and for encapsulation and installation on the support. This method avoids the use of a supporting film and of a bonder to fix the metallic joints to the film, namely elements that do not withstand high temperatures during encapsulation.

EP-A-0 260 490 relates to a bonding sheet that comprises a substrate having an opening, and a low-melting point bonding metal which closes the opening or is arranged on the peripheral portion of the opening, to project in the opening. According to the bonding sheet of the invention according to EP-A-0 260 490, a low-melting point bonding metal is interposed between a conductor pattern of a substrate and electrode terminals of an electronic component, and is bonded by thermocompression at a low temperature without melting the low-melting point bonding metal, so that bonding of a large number of electrode terminals can be completed by a single bonding operation.

US-A-5 615 476 relates to a method for producing chip cards having electronic modules that uses a standardized electronic module which is adapted to the production technique for the card in a last method step and connected with the card body by the selected technique.

US-A-5 990 546 relates to a semiconductor device in which the space between a semiconductor chip and an auxiliary wiring plate is sealed with resin. The auxiliary wiring plate has insulating layers and on both sides of the routing conductor, the insulating layer on the side of the semiconductor chip has a hole being led from the routing conductor to the electrode of the semiconductor chip, the metal filled in the hole and the metal bump formed so as to protrude from the hole serves as an inner electrode. The semiconductor device can be manufactured by the tape automated bonding (TAB) technique.

JP-A-2000021906 relates to the manufacture of a semiconductor chip having small outer dimensions through a simplified manufacturing process. The manufacturing process comprises forming a gap between neighbouring semiconductor chips by performing a first cutting along a scribe line (SL) for a wafer (W) stuck to a sheet (S). Then, the semiconductor chips are assembled and set in a metal mold for each sheet S. Molding resin is injected, and the forming surface of a bump is covered flatly with molding resin. At the same time, the gap is filed. Then, with the mold resin layer filled in the gap as a mark, a second cutting using a dicing wheel (DW) is performed. The wafer (W) is again divided into individual semiconductor chips. The bump can be used for facedown mounting intactly on the mounting substrate. No assembling whatever using a lead frame and packaging is required.

US-A-6 037 192 relates to a method of assembling an integrated circuit component onto a substrate by the use of a polymer adhesive having fluxing properties and a specified adhesive strength and temperature control volumetric change which is greater than that of a solder to be used between terminals of the component to terminals of the substrate. In the method the uncured polymer adhesive is located between the circuit component and the substrate and as the second component moves into its site position upon the substrate, the uncured polymer adhesive is compressed and is displaced outwardly from between the body of the component and the substrate. In the method, as an exterior force is required to displace the adhesive in this manner, glass microspheres are provided within the adhesive to limit the movement of the integrated circuit components towards the substrate. These microspheres are of a specified grid size and should also be sufficiently large to prevent glass microspheres from becoming trapped between the terminals of the component and of the substrate. The polymer adhesive has fluxing properties which enables it to be partially cured initially to hold the integrated circuit component in its required position, the curing action then being completed during a reflow soldering operation performed to join terminals of the component to the terminals of the substrate.

Therefore, it is an object of the invention to provide a method by means of which very compact devices can be obtained and which, in addition, is simple and inexpensive.

This object is achieved in accordance with the invention by a method according to claim 1.

The invention is based first and foremost on the recognition that a flexible foil is capable of further reducing the dimension of the device, in particular in the thickness direction. In addition, said flexible foil can very suitably be used to simplify the manufacture, particularly because only a single conductive layer and a single conductor pattern are necessary for the manufacture. The electrically conductive vias can be readily formed by providing the insulating layer with apertures and by rendering these apertures electrically conductive and, at the same time, securing the semiconductor body onto the conductor pattern in an electrically conductive manner. This is facilitated by the small thickness of the flexible foil, which implies that also the insulating layer has a small thickness. By detachably securing the flexible foil to a substrate, the disadvantages associated with the use of a flexible foil are avoided and a large number of semiconductor devices can be simultaneously manufactured in a very accurate and reliable manner. After the device has been finished, this substrate can be removed.

Thus, in a preferred embodiment of a method in accordance with the invention, the electrically conductive vias are formed by providing the insulating layer with apertures, as a result of which parts of the conductor pattern in the conductive layer are exposed, and introducing solder into said apertures, as a result of which the connection regions of the semiconductor body are electrically connected to the conductor pattern. The solder is preferably provided by means of a printing technique which is inexpensive as well as compatible with the use of a (thin) flexible foil.

In a favorable embodiment, a number of semiconductor bodies are simultaneously formed so as to be connected to each other, and subsequently secured, on a side opposite the connection regions, to an elastic foil, after which they are separated by means of sawing or etching, whereafter the elastic foil is stretched uniformly in all directions after which the individual semiconductor bodies are provided and secured onto the flexible foil. In this manner, the entire manufacturing process can be carried out on the scale of a so-termed wafer. As a result, this manufacturing process is easy, straightforward and inexpensive.

Preferably, prior to the provision of the semiconductor body on the flexible foil, a part thereof that is situated between the apertures in the insulating layer is provided with an electrically insulating fixing agent on which the semiconductor body is placed and the height of which determines the distance between the semiconductor body and the flexible foil. This has, inter alia, the important advantage that minimum stress is imparted on the conductive vias and the underlying part of the foil, as a result of which the reliability of the device is increased. In this manner, regulating and checking (controlling ?) the electrical insulation by means of a synthetic resin envelope between the semiconductor body and the foil can be improved too.

Preferably, after the provision of the semiconductor body on the flexible foil, a liquid, electrically insulating synthetic resin is provided between the semiconductor body and the flexible foil as well as around the semiconductor body, which synthetic resin is subsequently cured, after which the substrate is removed. Also this step can be carried out on "wafer scale". Use can also advantageously be made of the elastic foil discussed hereinabove. After the electrically conductive vias have been formed, for example by soldering, and after curing the enveloping synthetic resin, individual semiconductor devices can be obtained by means of sawing in two mutually perpendicular directions.

In another modification, a solid photoresist layer is used as the electrically insulating layer. This solid photoresist layer can be readily attached to a (different) substrate, and, consequently, the apertures necessary to form the vias can be readily formed in said solid photoresist layer. A suitable material for the insulating layer is a polyimide. The conductive layer is preferably made of copper and can be readily provided with the desired conductor pattern by means of photolithography and etching. The insulating layer preferably comprises a polyimide and can be provided with apertures in a similar way.

These and other aspects of the invention will be apparent from and elucidated with reference to the embodiment(s) described hereinafter.

In the drawings:
Fig. 1 is a diagrammatic, cross-sectional view, at right angles to the thickness direction, of a semiconductor device with a diode manufactured by means of a method in accordance with the invention,
Figs. 2A through 2F are diagrammatic, cross-sectional views, at right angles to the thickness direction, of the semiconductor device of Fig. 1 in successive stages of the manufacturing process using an embodiment of a method in accordance with the invention, and
Figs. 3A and 3B are diagrammatic, plan views of the manufacture of a part used, according to the method of Fig. 2, in Fig. 2E.

The Figures are not drawn to scale and, for clarity, particularly the dimensions in the thickness direction are exaggerated. Wherever possible, corresponding areas bear the same reference numeral.

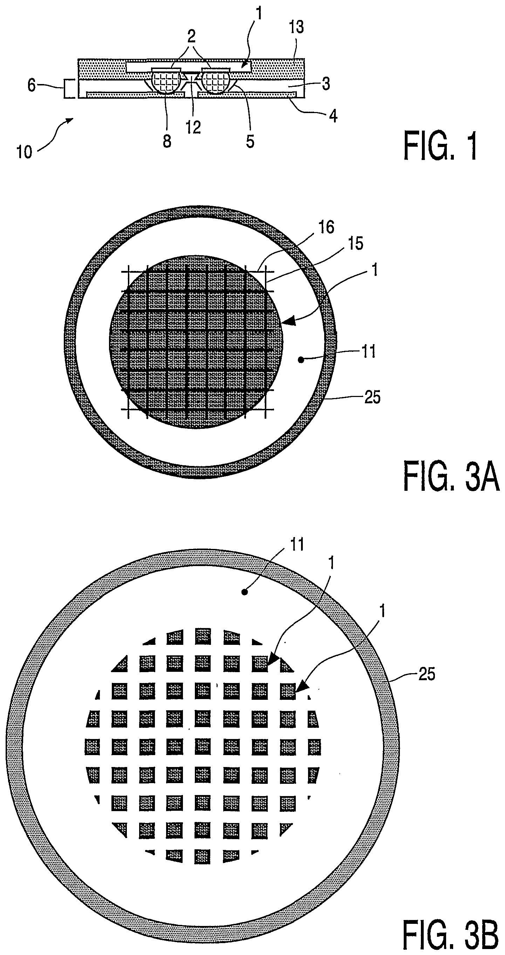

Fig. 1 is a diagrammatic, cross-sectional view, at right angles to the thickness direction, of a semiconductor device with a diode, which is manufactured by means of a method in accordance with the invention. The device 10 comprises a semiconductor body 1 with an active element, in this case a diode, which is provided with connection regions 2 situated at the surface of the semiconductor body 1. By means of solder 8, these connection regions are electroconductively connected to a conductor pattern 4, which in this case comprises two connection conductors 4, and which is situated in a conductive layer 4, in this case of copper, which forms part of a (flexible) foil 6 which, apart from the conductive layer 4, comprises an electrically insulating layer 3 wherein openings 5 are formed at the location of the soldered joint 8. Between the semiconductor body 1 and the foil 6, fixing agents are provided on the insulating layer 3, which support the semiconductor body 1 and unburden the soldered joints 8. Between the semiconductor body 1 and the foil 6, a synthetic resin envelope 13, in this case of an epoxy material 13, is situated (around the fixing means 12 and the soldered joints 8), which synthetic resin envelope is also situated around the semiconductor body 1. A method of manufacturing, which will be described hereinafter, enables this device 10 to be very compact, particularly in the thickness direction, and to be readily manufacturable at low cost. The device 10 of this example is manufactured as follows, using an embodiment of a method in accordance with the invention.

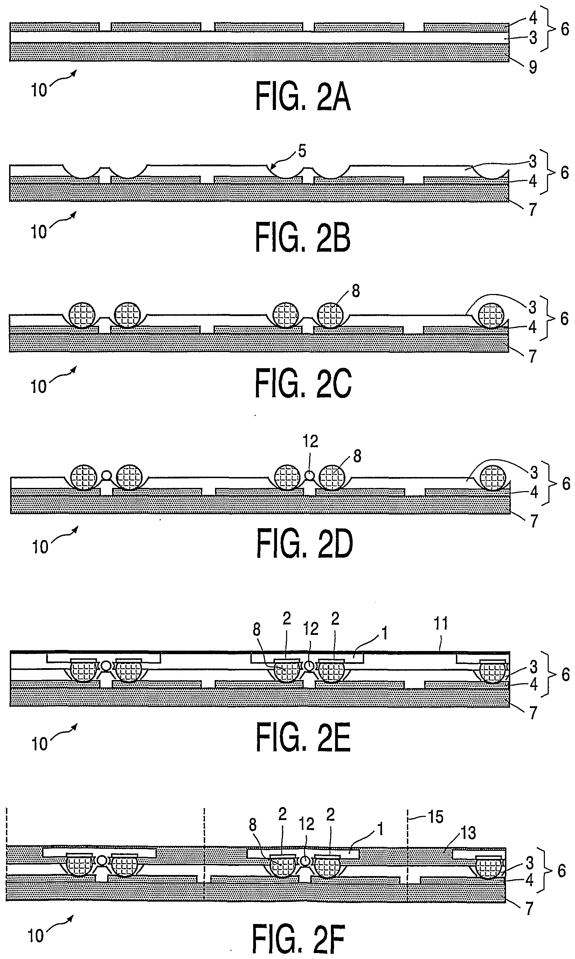

Figs. 2A through 2F are diagrammatic, cross-sectional views, at right angles to the thickness direction, of the semiconductor device of Fig. 1 in successive stages of the manufacture, using an embodiment of a method in accordance with the invention. Figs. 3A and 3B are diagrammatic, plan views of the manufacture of a part used, in the method of Fig. 2, in Fig. 2E. Use is made (see Fig. 2A) of a flexible foil 6 which comprises an electrically insulating layer 3, in this case a polyimide layer having a thickness of 50 µm, and a conductive layer 4, in this case a copper layer having a thickness of 17 µm. On the side of the insulating layer 3, the foil 6 is detachably secured to a substrate 9, in this case of glass having a thickness of 5 mm, by means of a thermoplastic or UV-soluble adhesive. By means of photolithography and etching with an etchant that is suitable for copper, the conductive layer 4 is subsequently converted to a conductor pattern 4 that is suitable for a diode.

Subsequently, (see Fig. 2B) on the side of the conductor pattern 4, the foil 6 is also detachably secured to a second substrate 7, in this case also made of glass having a thickness of 5 mm, by means of an adhesive similar to the one described hereinabove, after which the first substrate 9 is removed. The insulating layer 3, which in this case comprises a polyimide layer 3, is subsequently provided with openings 5 exposing the conductor pattern 4 by means of photolithography and etching using a customary etchant. Subsequently, (see Fig. 2C) solder 8 is provided in these openings 5, said solder comprising in this case a Sn-Ag-Cu-Sb solder 8. Preferably, as in this example, use is made of a so-termed printing technique. This technique is simple and very suitable for mass production.

Subsequently, (see Fig. 2D) a fixing agent 12, in this case a liquid, yet viscous epoxy material 12, is provided between the solder regions 8 on the insulating layer 3. For this purpose use is made of a so-termed dispensing technique. The epoxy material can be cured at 200°C for ½ to 1 minute.

Next, (see Fig. 2E), an elastic foil 11, in this case of rubber, is provided above the substrate 7. Semiconductor bodies 1 are detachably secured to the lower side of the elastic foil 11 in such a way that the side of the semiconductor bodies that is provided with connection regions 2 faces the substrate 7, and the distance between the semiconductor bodies corresponds to the distance between each pair of solder regions 8. The foil 11 is arranged at such a small distance from the substrate 7 that each semiconductor body 1 rests on a fixing agent 12 and contacts the solder regions 8 at the location of the connection regions 2. By means of a suitable heat treatment, in this case at 250 °C for a ½ minute, the semiconductor body 1 is subsequently soldered to the conductor pattern 4. In this example, the fixing agent 12 is also cured in this step.

Subsequently, (see Fig. 2F) a liquid epoxy material 13, which forms a customary enveloping material, is provided around the semiconductor bodies 1 and between each semiconductor body 1 and the foil 6, a synthetic resin envelope 13 being formed from said epoxy material after curing by means of, for example, a customary thermal treatment. Next, the foil 11 is removed. Subsequently, individual devices 10 are obtained by sawing in two mutually perpendicular directions 15, 16, only direction 15 being shown in Fig. 2E, which individual devices are suitable for surface mounting, after removal of the substrate 7, and are very compact and inexpensive by virtue of the method in accordance with the invention. It is to be noted that the conductor pattern 4 is interrupted at the location of the saw cuts 15, 16, as is clearly shown in Fig. 2. By virtue thereof, the sawing process to form individual semiconductor devices 10 is facilitated.

Further details regarding the manufacture of the foil 11 provided with semiconductor bodies 1, as shown in Fig. 2E, are shown in Fig. 3A and Fig. 3B. They show (see Fig. 3 A), how a large number of semiconductor bodies 1 are manufactured within a "wafer" 1. Said wafer 1 is subsequently detachably secured onto an elastic foil 11 that is situated within a ring 25 whose diameter can be enlarged. By means of, for example, sawing in two mutually perpendicular directions 15, 16, the wafer 1 is divided into individual semiconductor bodies 1. Subsequently, (see Fig. 3B) the foil is uniformly stretched in all directions by enlarging the diameter of the ring 25, as a result of which the spacing between the semiconductor bodies is increased. This spacing is chosen to be equal to the mutual distance between each pair of solder regions 8 on the foil 6 in Fig. 2E.

The invention is not limited to the example given herein, and within the scope of the invention many modifications and variations are possible to those skilled in the art. For example, thicknesses and materials may be used which are different from those employed in the example. The invention is particularly suitable for the manufacture of (semi-)discrete semiconductor devices, such as diodes and transistors, but it may also advantageously be used, under certain conditions, to manufacture (more or less) integrated circuits.

It is emphasized that the different process steps do not necessarily have to be carried out at one location or in one factory. For example, particularly the first steps wherein the conductor pattern is formed in the conductive layer and the openings are formed in the insulating layer can be carried out at a different location. Also regarding the sequence or exact time of different steps, many variations are possible. For example, the foil 11 can also be removed before the synthetic resin envelope 13 is provided and formed.

## Claims

1. A method of manufacturing a semiconductor device (10) which is suitable for surface mounting, whereby the method includes the steps of
forming a flexible foil (6) comprising a conductor pattern (4) and an electrically insulating layer (3), detachably securing the flexible foil (6) to a substrate (7) on the side of the conductor pattern (4);
forming electrically conductive vias (5) in the insulating layer (3);
positioning a semiconductor body (1) comprising an active element and provided with connection regions (2) situated at the surface of the semiconductor body (1) on the flexible foil (6);
connecting the connection regions (2) of the active element to the conductor pattern (4) by means of the electrically conductive vias (5) in the insulating medium (3); and
subsequently removing the substrate (7), **characterized in that**, prior to the formation of the electrically conductive vias (5) and prior to the positioning of the semiconductor body (1) on the flexible foil (6) that is to be detachably secured to the substrate (7), an assembly consisting of a conductive layer and the insulating layer (3) is detachably secured, on the side of the insulating layer (3), to another substrate (9), after which the conductor pattern (4) is formed in the conductive layer, thereby forming the flexible foil (6), whereafter the flexible foil (6) is detachably secured, on the side of the conductor pattern (4), to the substrate (7), after which the other substrate (9) is removed.

2. A method as claimed in claim 1, **characterized in that** the electrically conductive vias (5) are formed by providing the insulating layer (3) with apertures, as a result of which parts of the conductor pattern (4) in the conductive layer are exposed, and introducing solder (8) into said apertures, as a result of which the connection regions (2) of the semiconductor body (1) are electrically connected to the conductor pattern (4).

3. A method as claimed in any one of the preceding claims, **characterized in that** a number of semiconductor bodies (1) are simultaneously formed so as to be connected to each other, and subsequently secured, on a side opposite the connection regions (2), to an elastic foil (11), after which they are separated by means of sawing or etching, whereafter the elastic foil (11) is stretched uniformly in all directions after which the individual semiconductor bodies (1) are provided and secured onto the flexible foil (6).

4. A method as claimed in any one of preceding claims, **characterized in that** the prior to the provision of the semiconductor body (1) on the flexible foil (6), a part thereof that is situated between the electrically conductive vias (5) in the insulating layer (3) is provided with an electrically insulating fixing agent (12) on which the semiconductor body (1) is placed and the height of which determines the distance between the semiconductor body (1) and the flexible foil (6).

5. A method as claimed in any one of the preceding claims, **characterized in that** after the provision of the semiconductor body (1) on the flexible foil (6), a liquid, electrically insulating synthetic resin (13) is provided between the semiconductor body (1) and the flexible foil (6) as well as around the semiconductor body (1), which synthetic resin is subsequently cured.

6. A method as claimed in claim 5, **characterized in that**, after curing the synthetic resin (13), the semiconductor device (10) is obtained by sawing in two mutually perpendicular directions (15,16), after which the device (10) is removed from the substrate (7).

7. A method as claimed in any one of the preceding claims, **characterized in that** a solid photoresist layer (3) is used for the electrically insulating layer (3).

8. A method as claimed in any one of the preceding claims, **characterized in that** for the material of the electrically insulating layer (3) use is made of a polyimide, and for the material of the conductive layer (4) use is made of copper.

## Patentansprüche

1. Verfahren zur Herstellung einer Halbleitervorrichtung (10), die für eine Oberflächenmontage geeignet ist, wobei das Verfahren folgende Schritte beinhaltet:
Ausbilden einer flexiblen Folie (6), die eine Leiterstruktur (4) und eine elektrisch isolierende Schicht (3) umfasst, lösbares Befestigen der flexiblen Folie (6) an einem Substrat (7) auf der Seite der Leiterstruktur (4);
Ausbilden elektrisch leitender Durchkontaktierungen (5) in der Isolierschicht (3);
Positionieren eines Halbleiterkörpers (1), der ein aktives Element umfasst und mit auf der Oberfläche des Halbleiterkörpers (1) befindlichen Verbindungsbereichen (2) versehen ist, auf der flexiblen Folie (6);
Verbinden der Verbindungsbereiche (2) des aktiven Elements mit der Leiterstruktur (4) mittels der elektrisch leitenden Durchkontaktierungen (5) in dem Isoliermedium (3); und
anschließendes Entfernen des Substrats (7), **dadurch gekennzeichnet, dass** vor der Ausbildung der elektrisch leitenden Durchkontaktierungen (5) und vor dem Positionieren des Halbleiterkörpers (1) auf der flexiblen Folie (6), die lösbar an dem Substrat (7) zu befestigen ist, eine aus einer leitfähigen Schicht und der Isolierschicht (3) bestehende Anordnung auf der Seite der Isolierschicht (3) lösbar an einem anderen Substrat (9) befestigt wird, wonach die Leiterstruktur (4) in der leitfähigen Schicht ausgebildet wird und dadurch die flexible Folie (6) ausgebildet wird, woraufhin die flexible Folie (6) auf der Seite der Leiterstruktur (4) lösbar an dem Substrat (7) befestigt wird, wonach das andere Substrat (9) entfernt wird.

2. Verfahren nach Anspruch 1, **dadurch gekennzeichnet, dass** die elektrisch leitenden Durchkontaktierungen (5) durch Versehen der Isolierschicht (3) mit Öffnungen, wodurch Teile der Leiterstruktur (4) in der leitfähigen Schicht freigelegt werden, und Einbringen von Lot (8) in die Öffnungen, wodurch die Verbindungsbereiche (2) des Halbleiterkörpers (1) elektrisch mit der Leiterstruktur (4) verbunden werden, ausgebildet werden.

3. Verfahren nach einem der vorangehenden Ansprüche, **dadurch gekennzeichnet, dass** eine Anzahl von Halbleiterkörper (1) gleichzeitig ausgebildet werden, um miteinander verbunden zu werden, und anschließend auf einer den Verbindungsbereichen (2) gegenüberliegenden Seite an einer elastischen Folie (11) befestigt werden, wonach sie durch Sägen oder Ätzen getrennt werden, woraufhin die elastische Folie (11) einheitlich in allen Richtungen gedehnt wird, wonach die einzelnen Halbleiterkörper (1) auf der flexiblen Folie (6) bereitgestellt und befestigt werden.

4. Verfahren nach einem der vorangehenden Ansprüche, **dadurch gekennzeichnet, dass** vor der Bereitstellung des Halbleiterkörpers (1) auf der flexiblen Folie (6) ein zwischen den elektrisch leitenden Durchkontaktierungen (5) in der Isolierschicht (3) befindlicher Teil davon mit einem elektrisch isolierenden Fixiermittel (12) versehen wird, auf dem der Halbleiterkörper (1) platziert wird und dessen Höhe den Abstand zwischen dem Halbleiterkörper (1) und der flexiblen Folie (6) bestimmt.

5. Verfahren nach einem der vorangehenden Ansprüche, **dadurch gekennzeichnet, dass** nach der Bereitstellung des Halbleiterkörpers (1) auf der flexiblen Folie (6) eine Flüssigkeit, ein elektrisch isolierendes Kunstharz (13) zwischen dem Halbleiterkörper (1) und der flexiblen Folie (6) sowie um den Halbleiterkörper (1) herum bereitgestellt wird, wobei das Kunstharz anschließend gehärtet wird.

6. Verfahren nach Anspruch 5, **dadurch gekennzeichnet, dass** nach dem Härten des Kunstharzes (13) die Halbleitervorrichtung (10) durch Sägen in zwei zueinander rechtwinkligen Richtungen (15, 16) erhalten wird, wonach die Vorrichtung (10) von dem Substrat (7) entfernt wird.

7. Verfahren nach einem der vorangehenden Ansprüche, **dadurch gekennzeichnet, dass** für die elektrisch isolierende Schicht (3) eine feste Fotolackschicht (3) verwendet wird.

8. Verfahren nach einem der vorangehenden Ansprüche, **dadurch gekennzeichnet, dass** für das Material der elektrisch isolierenden Schicht (3) ein Polyimid verwendet wird und für das Material der leitfähigen Schicht (4) Kupfer verwendet wird.

## Revendications

1. Procédé de fabrication d'un dispositif semi-conducteur (10) adapté pour le montage en surface, grâce auquel le procédé inclut les étapes de :
former une feuille souple (6) comprenant un motif conducteur (4) et une couche électriquement isolante (3), fixant, de manière amovible, la feuille souple (6) sur un substrat (7) sur le côté du motif conducteur (4) ;
former des trous électriquement conducteurs (5) dans la couche isolante (3) ;
positionner un corps semi-conducteur (1) comprenant un élément actif et muni de régions de connexion (2) situées à la surface du corps semi-conducteur (1) sur la feuille souple (6) ;
connecter les régions de connexion (2) de l'élément actif avec le motif de conducteur (4) au moyen des trous électriquement conducteurs (5) dans le milieu isolant (3) ; et
enlever ensuite le substrat (7), **caractérisé en ce que**, avant la formation des trous électriquement conducteurs (5) et avant le positionnement du corps semi-conducteur (1) sur la feuille souple (6) qui doit être fixée de manière amovible sur le substrat (7), un ensemble consistant en une couche conductrice et la couche isolante (3) est fixé de manière amovible, sur le côté de la couche isolante (3), sur un autre substrat (9), après quoi le motif de conducteur (4) est formé dans la couche conductrice, en formant ainsi la feuille souple (6), après quoi la feuille souple (6) est fixée de manière amovible, sur le côté du motif conducteur (4), sur le substrat (7), après quoi l'autre substrat (9) est enlevé.

2. Procédé selon la revendication 1, **caractérisé en ce que** les trous électriquement conducteurs (5) sont formés en prévoyant des ouvertures dans la couche isolante (3), à la suite de quoi des parties du motif conducteur (4) de la couche conductrice sont exposées, et en introduisant de la brasure (8) dans lesdites ouvertures, à la suite de quoi les régions de connexion (2) du corps semi-conducteur (1) sont électriquement connectées au motif conducteur (4).

3. Procédé selon l'une quelconque des revendications précédentes, **caractérisé en ce qu'**un certain nombre de corps semi-conducteurs (1) sont formés simultanément de manière à être connectés les uns avec les autres, puis ensuite fixés, sur un côté opposé aux régions de connexion (2), à une feuille élastique (11), après quoi ils sont séparés par sciage ou gravure, après quoi la feuille élastique (11) est étirée uniformément dans toutes les directions, après quoi les corps semi-conducteurs (1) individuels sont fournis et fixés sur la feuille souple (6).

4. Procédé selon l'une quelconque des revendications précédentes, **caractérisé en ce que**, avant la fourniture du corps semi-conducteur (1) sur la feuille souple (6), une partie de celle-ci qui est située entre les trous électriquement conducteurs (5) dans la couche isolante (3) est munie d'un agent fixant électriquement isolant (12) sur lequel est placé le corps semi-conducteur (1) et dont la hauteur détermine la distance qui sépare le corps semi-conducteur (1) et la feuille souple (6).

5. Procédé selon l'une quelconque des revendications précédentes, **caractérisé en ce que**, après la fourniture du corps semi-conducteur (1) sur la feuille souple (6), un liquide, de la résine synthétique électriquement isolante (13), est fournie entre le corps semi-conducteur (1) et la feuille souple (6) ainsi qu'autour du corps semi-conducteur (1), laquelle résine synthétique est ensuite durcie.

6. Procédé selon la revendication 5, **caractérisé en ce que**, après durcissement de la résine synthétique (13), le dispositif semi-conducteur (10) est obtenu par sciage dans deux directions perpendiculaires l'une à l'autre (15, 16), après quoi le dispositif (10) est enlevé du substrat (7).

7. Procédé selon l'une quelconque des revendications précédentes, **caractérisé en ce qu'**une couche de résine photosensible pleine (3) est utilisée pour la couche électriquement isolante (3).

8. Procédé selon l'une quelconque des revendications précédentes, **caractérisé en ce que**, comme matériau de la couche électriquement isolante (3), on utilise un polyimide, et comme matériau pour la couche conductrice (4), on utilise du cuivre.
